# EUROPÄISCHE PATENTSCHRIFT

(11) **EP 1 499 443 B1**
(45) Veröffentlichungstag und Bekanntmachung des Hinweises auf die Patenterteilung: **13.06.2012**
(21) Anmeldenummer: 03747428.5
(22) Anmeldetag: 29.04.2003
(51) Int. Cl.: B01L 3/00, C30B 7/00, B01J 19/00

(54) **VORRICHTUNG ZUR PROTEINKRISTALLISATION**
DEVICE FOR PROTEIN CRYSTALLISATION
DISPOSITIF POUR LA CRISTALLISATION DE PROTEINES

(30) Priorität: 30.04.2002 AT 6682002
(43) Veröffentlichungstag der Anmeldung: 26.01.2005
(73) Patentinhaber: Greiner Bio-One GmbH, 72636 Frickenhausen (DE)
(72) Erfinder: KNEBEL, Günther, 72622 Nürtingen (DE); D'ARCY, Allan, F-68220 Hegeheim (FR); CUDNEY, Robert, Earl, US Laguna Niguel, CA 92677 (US)
(74) Vertreter: Burger, Hannes
(86) Internationale Anmeldenummer: PCT/EP2003/004454
(87) Internationale Veröffentlichungsnummer: WO 2003/092892

(56) Entgegenhaltungen:
- WO-A-99/42608
- WO-A-99/55826
- WO-A-02/081785
- GB-A- 2 321 446
- US-A- 3 728 228
- US-A- 4 204 045
- US-A- 4 673 651
- US-A- 5 429 236
- US-A1- 2001 032 582
- CHAYEN N E ET AL: "MICROBATCH CRYSTALLIZATION UNDER OIL - A NEW TECHNIQUE ALLOWING MANY SMALL-VOLUME CRYSTALLIZATION TRIALS" JOURNAL OF CRYSTAL GROWTH, NORTH-HOLLAND PUBLISHING CO. AMSTERDAM, NL, Bd. 122, Nr. 1 / 4, 2. August 1992 (1992-08-02), Seiten 176-180, XP000306492 ISSN: 0022-0248

## Beschreibung

Die Erfindung betrifft einen Behälter mit einem Grundkörper bestehend aus einer Bodenplatte und von dieser zumindest annähernd senkrecht abstehenden Seitenwänden und mit im Grundkörper angeordneten Küvetten, die als Vertiefung in der Bodenplatte (3) ausgebildet sind, wobei die Seitenwände (4) der Bodenplatte (3) in zumindest annähernd entgegengesetzter Richtung zu den Vertiefungen zur Aufnahme eines Volumens angeordnet sind, sowie die Verwendung des Behälters entsprechend den Ansprüchen 29 und 30.

Durch die Sequenzierung des menschlichen Genoms erlangte man die Kenntnis, dass ca. 30.000 menschliche Gene vorhanden sind. Dies entspricht ungefähr 1 % des menschlichen Genoms. Jedes Gen im menschlichen Genom kodiert wiederum für mehr als ein Protein. Man nimmt daher an, dass es zwischen 200.000 bis 500.000 Proteine gibt, wobei allerdings nur ein Bruchteil der Proteine in einem bestimmten Zelltyp exprimiert wird. Hinzu kommt, dass Proteine auch posttranslationalen Veränderungen unterliegen. Sie erfolgen bevor die Proteine ihre endgültige biologische Funktion entfalten.

Man weiß inzwischen, dass nur geringfügige Proteinmodifizierungen und Veränderungen in der Natur der Proteininteraktionen und der Proteinlokalisation einen dramatischen Effekt auf die Zellphysiologie haben können. Auch die Konformation eines Proteins ist essentiell um die Rolle, die es ausübt, zu verstehen. Die Form eines Proteins ist auch pharmakologisch von großer Relevanz, weil die meisten Pharmazeutika aufgrund ihrer Fähigkeit mit einem bestimmten Proteinmolekül zu interagieren, ihre Wirkung entfalten.

Um die Funktion eines Biomakromoleküls auf atomaren Niveau zu verstehen, bedarf es des Wissens der dreidimensionalen Struktur. Die beste Methode um strukturelle Informationen über das Biomakromolekül zu erhalten, ist die Röntgenstrahlkristallographie. Sie ermöglicht die Bestimmung des Aufbaus eines Kristalls mit Hilfe der Messung der Reflexion und Beugung von Röntgenstrahlen an den Gitternetzebenen. Eine weitere Methode zur Proteinstrukturanalyse, die magnetische Kernresonanzspektroskopie (NMR), ist auf kleinere Proteine bis derzeit maximal 200 bis 300 kDa aus Lösungen limitiert. Im Falle der Röntgenstrahlkristallographie gibt es keine obere Grenze für die Masse der zu analysierenden Proteine, solange geeignete Kristalle erhalten werden können.

Die Morphologie eines Kristalls wird als Folge einer inneren Regelmäßigkeit angesehen.

Auch organische Materialien können Kristalle formen. Allerdings findet man organische Moleküle und Proteine in der Natur nur selten in kristalliner Form und muss deshalb Bedingungen finden um Proteinkristalle für die Strukturaufklärung wachsen zu lassen. Einige Proteine kristallisieren sehr gut, bei anderen wiederum ist es sehr zeitaufwendig die geeigneten Kristallisationsbedingungen zu finden. Einige Proteine konnten bis zum heutigen Tage nicht kristallisiert werden.

Vielfach wird die Proteinkristallisation auch als eine Kunst bezeichnet, weil ein Kristallzüchter nicht nur große Ausdauer und Geduld, sondern auch eine glückliche Hand braucht.

Die meisten Biomakromoleküle, wie z.B. Proteine, sind nur dann aktiv wenn die Polypeptidketten in ihrem nativen, korrekt gefalteten Zustand vorliegen. Sie müssen daher aus wässrigen Lösungen unter nicht denaturierenden Bedingungen kristallisiert werden. Die Kristallisation wird durch die Zugabe eines geeigneten Präzipitationsmittels eingeleitet, was zu einer Übersättigung und somit zur Präzipitation oder Kristallisation des Proteins führt. Alle Kristallisationsexperimente hängen von einer Vielzahl von Parametern, wie z.B. pH-Wert, Konzentration des Präzipitationsmittels, Temperatur, Ionenkonzentration, Liganden, etc., ab. Eine Kristallisation erfolgt nur, wenn eine geeignete Kombination von bestimmten Parametern vorliegt. Jedes Protein verhält sich individuell anders und unterscheidet sich in ihren optimalen Kristallisationsbedingungen, welche entweder durch Zufall oder durch ein enormes Arbeitspensum gefunden werden.

Proteine tragen an ihrer Oberfläche Aminosäuren mit geladenen, ionischen Gruppen. Es gilt nun, Bedingungen zu finden, unter denen die Proteinmoleküle sich langsam geordnet assoziieren. Dies gelingt im Falle der Proteinkristallisation durch langsames Verändern der Wassermenge, in welcher das Protein gelöst vorliegt, z.B. durch anorganische Salze. Das Salz bindet Wassermoleküle, wenn es in Lösung geht, weil es sich mit einer Wasserhülle umgibt und so dem Protein diese Wassermoleküle entzieht. Wird der Sättigungspunkt überschritten, beginnt das Protein auszufallen. Man kann die Kristallisation aber auch durch den gegenteiligen Prozess erreichen, indem man die Wassermenge steigert und so ein hydrophobes Enzym zur Kristallisation bringen kann. Neben Salzen können auch oberflächenaktive Substanzen wie das Detergens Polyethylenglykol zur Beeinflussung der Proteinhydrathülle verwendet werden. Um das Protein letztendlich kristallisieren zu können, müssen außerdem der richtige pH-Wert und die richtige Temperatur eingestellt werden. Proteinkristalle enthalten zahlreiche Wassermoleküle im Kristallgitter (30 % bis 70 %). Würde man sie wie Kristalle niedermolekularer organischer oder anorganischer Substanzen behandeln, würden sie austrocknen - und schließlich könnte dann der gesamte Kristall zerstört werden.

Als Ergebnis einer Strukturanalyse erhält man das Abbild des Inhalts der Elementarzelle in Form einer Elektronendichte, da die Röntgenstrahlung an den Elektronen gebeugt wurde. Wie genau und detailliert die Elektronendichte bestimmt werden kann, hängt von der räumlichen Auflösung und letztendlich von der Qualität des vermessenen Kristalls ab. Durch Unordnungen und Baufehler im Kristall wird die Auflösung reduziert.

Es wurden Methoden für die Austestung so vieler wie möglich verschiedener Kristallisationsparameter geschaffen. Nachdem eine Vielzahl von Proteinen gescreent werden muss, um einen geeigneten Kristall für die Röntgenstrahlkristallanalyse zur Verfügung zu stellen, ist es notwendig eine Automatisierung der Kristallisationsexperimente herbei zu führen.

Die weitverbreitete Linbro-Platte zur Proteinkristallisation enthält 24 Küvetten, jedes mit einem Fassungsvermögen von ca. 3 ml, die individuell mit 24 Deckgläsern verschlossen werden. Obwohl zur Zeit erste Roboter zur Automatisierung der Kristallisationsexperimente für diese Platte auf dem Markt sind, treffen diese nicht die Erfordernisse für das Highthroughputscreening wie es für die dreidimensionale Proteinstrukturanalyse notwendig wäre. Weiters ist an der Linbro-Platte nachteilig, dass ihr Format nicht dem standardisierten Mikrotiterplattenformat entspricht, so dass sehr kostenintensive Anpassungen an Robotersystemen zur Bearbeitung für dieses Format erforderlich sind.

Für die Kristallisation von Proteinen haben sich die sogenannte "hanging drop" und auch "sitting drop" Methode in Kristallisationsplatten mit 24 Küvetten als geeignet erwiesen. Weil sehr häufig nur geringe Mengen an aufgereinigtem Protein (wenige Milligramm) zur Verfügung stehen ist das "hanging drop" Verfahren derzeit noch die Methode der Wahl zur Proteinkristallisation. Ein 5 µl bis 15 µl großer Tropfen der konzentrierten Proteinlösung mit entsprechenden Präzipitationssubstanzen wird auf ein Mikroskopiergläschen aufgetragen. Dieses Gläschen wird dann kopfüber über einem Reservoir platziert, welches etwa 500 µl einer konzentrierten Lösung an Präzipitationssubstanzen ohne Proteine enthält, so dass der Tropfen mit der Proteinlösung direkt über der Reservoirlösung (durch Adhäsionskräfte am Gläschen gehalten) positioniert ist. Das Deckgläschen versiegelt unter Zuhilfenahme von Silikonfett die Küvette, so dass das System nach außen hin hermetisch abgeschlossen ist. Sobald sich ein Gleichgewicht zwischen den beiden Lösungen eingestellt hat, kann das Protein kristallisieren.

Der Kristallisationsmechanismus ist zur Zeit noch nicht vollständig aufgeklärt und es bedarf daher eines sehr großen Aufwands um die Struktur von Biomakromolekülen darzustellen. Aus dem Stand der Technik sind Mikroplatten mit 24 Küvetten zur Kristallisation bekannt, allerdings ist für diese Platten der Automatisierungsgrad sehr niedrig, weil die standardisierten Automatisierungsgeräte für Mikroplatten mit 96 bzw. einem Vielfachen davon Küvetten konzipiert sind. Eine Automatisierung kann daher nur nach kostenintensiver Produktion speziell angefertigter Pipettier- bzw. Detektionseinrichtungen erfolgen. Außerdem kann mit diesen Platten nur eine geringe Anzahl (nämlich 24) von Biomakromolekülen analysiert werden. Diese Platten sind des weiteren vorwiegend zur Kristallisation von Biomakromoleülen mittels "hanging-" bzw. "sitting- drop" Methode ausgelegt und können nicht mittels der Kristallisation unter Öl-Methode (Microbatch-Methode) analysiert werden.

Aufgabe der Erfindung ist es daher, eine Möglichkeit zur Steigerung des Automatisierungsgrades bei der Analyse von Biomakromolekülen anzugeben. Eine Teilaufgabe der Erfindung liegt insbesondere darin, eine Vorrichtung zur Kristallisation von Biomakromolekülen zu schaffen, mit welcher es ermöglicht wird eine Vielzahl von unterschiedlichen Parametern gleichzeitig zu untersuchen.

Die Aufgabe der Erfindung wird durch den Behälter, entsprechend den Merkmalen im Kennzeichenteil des Anspruches 1 gelöst. Es erweist sich von Vorteil, dass durch die Ausbildung der Küvetten als Vertiefungen in der Bodenplatte ein niedrigeres Niveau der überschichtenden hydrophoben Flüssigkeit notwendig ist. Einerseits kann durch das niedrige Niveau der hydrophoben Flüssigkeit ein Hinauskriechen der Flüssigkeit aufgrund der Kapillarwirkung entlang der Seitenwände des Behälters vermieden werden und somit die Kontaminationsgefahr durch beispielsweise verunreinigte Arbeitsflächen sowohl für das Laborpersonal als auch für weitere Analysen vermieden werden. Andererseits entstehen durch den geringeren Bedarf an hydrophober Flüssigkeitsmenge niedrigere Kosten. Ein niedrigeres Niveau der hydrophoben Flüssigkeit begünstigt außerdem das Kristallisationsverhalten der Biomakromoleküle, indem der Kristallisationsprozess früher einsetzt. Weiters ist von Vorteil, dass auch ein geringeres Volumen sowohl der an der Reaktion beteiligten Präzipitationslösungen als auch der zu analysierenden Biomakromoleküle benötigt wird. Vorteilhaft daran ist, dass durch das Anbringen der Einrichtung im Behälter Schwankungen im Flüssigkeitsniveau während des Transports des Behälters sehr niedrig gehalten werden. Vorteilhaft daran ist auch, dass Schwankungen der hydrophoben Flüssigkeit, welche die Küvetten überschichtet, ausgeglichen werden können. Sowohl durch die manuelle als auch durch die automatisierte Bearbeitung des Behälters kann es immer wieder zu geringfügigen Erschütterungen kommen, welche eine Umpositionierung des Biomakromoleküls und somit eine Störung des Kristallisationsprozesses verursachen könnten. Durch den Einsatz der Einrichtung wird eine konstante Positionierung des Biomakromoleküls in der Ausnehmung während des gesamten Kristallisationsprozesses, die mehrere Tage, sogar einige Monate, dauern kann, gewährleistet auch wenn der Behälter gegebenenfalls mehrmals den Standort wechseln muss. Weiters ist von Vorteil, dass durch die Funktion eines Wellenbrechers eine effiziente automatisierte Bearbeitung mit höherer Geschwindigkeit erfolgen kann. Es wird dennoch ermöglicht, eine durchgehende Überschichtung der Küvetten mit dem hydrophoben Flüssigkeitsmittel zu ermöglichen, weil die Stege beabstandet zur Aufstandsfläche angeordnet sind und somit immer eine konstante Konzentration des hydrophoben Flüssigkeitsmittels über jeder Ausnehmung bzw. über der Gesamtheit der Küvetten gegeben ist.

Gemäß Anspruch 2 werden auf vorteilhafte Weise durch die gleichartige Anordnung der Küvetten bei der automatisiert durchgeführten Manipulation des Behälters relativ zu gleichen Bezugspunkten der Küvetten auch für verschiedene Küvetten stets die gleichen parallel zur Aufstandsebene auszuführenden Bewegungen durchgeführt.

Von Vorteil nach Anspruch 3 erweist sich, dass viele verschiedene Biomakromoleküle gleichzeitig analysiert werden können.

Von Vorteil ist eine Weiterbildung nach Anspruch 4, wobei durch die standardisierte Anordnung der konischen bzw. zylindrischen Küvetten eine sehr platzökonomische Gestaltung des Behälters erreicht wird. Es wird der gesamte zur Verfügung stehende Platz von den Küvetten besonders gut ausgenützt.

Vorteilhaft ist weiters eine Ausgestaltung nach Anspruch 5, wonach nur ein sehr geringes Volumen für die Reaktion eingesetzt werden muss. Durch die Verwendung der geringen Volumina wird eine sehr kosteneffektive Analyse ermöglicht.

Von Vorteil ist dabei eine Ausgestaltung nach Anspruch 6, wonach durch die regelmäßige Anordnung der Küvetten eine besonders einfache Bearbeitung des Behälters möglich wird. Es wird sowohl das Befüllen der Küvetten erleichtert, als auch die Beobachtung der Probe während der Verarbeitung und das Ernten der Kristalle.

Als vorteilhaft erweist sich weiters die Ausgestaltung nach den Ansprüchen 7' und 8, wonach durch eine Oberflächenbehandlung die Ausbildung von Biomakromoleküle verbessert werden kann.

Vorteilhaft ist dabei die Ausformung des Behälters nach Anspruch 9, wobei die Böden der Küvetten zumindest annähernd konvex gekrümmt sind, wird der Vorteil erzielt, dass Flüssigkeitstropfen im derart geformten Küvetten leichter aufgenommen werden und sich der Tropfen besser im Zentrum der Küvette ansiedelt. Beim Einsetzen eines Flüssigkeitstropfens wirkt nämlich die Oberflächenspannung der Adhäsion zwischen den Wänden einer Ausnehmung und der Grenzfläche des Flüssigkeitstropfens um so weniger entgegen, je mehr die Form der Ausnehmung der annähernd kugelförmigen Krümmung eines Flüssigkeitstropfens entspricht.

Von Vorteil ist dabei eine Ausgestaltung nach Anspruch 10, wonach eine automatisierte Bearbeitung des Behälters und insbesondere der Küvetten zur Kristallisation von Biomakromolekülen erleichtert wird.

Weiters erweist sich eine Ausgestaltung nach Anspruch 11 von Vorteil, weil eine optische Kontrolle während des Arbeitsvorganges bzw. während der Inkubation des Behälters ermöglicht wird. Dadurch kann in geeigneter Weise noch nach Zubereitung des Reaktionsgemisches in die Reaktion eingriffen werden.

Von Vorteil ist auch die Weiterbildung nach Anspruch 12, wonach durch die teilweise lichtundurchlässige Ausbildung Streulicht, welches das Messergebnis fälschen könnte, während der Detektion vermieden werden kann.

Vorteilhaft ist weiters eine Weiterbildung nach Anspruch 13, wonach ein Verschieben bzw. Verrutschen der Tropfen in den Küvetten, auch wenn deren Wände nur eine minimale Höhe, wie z.B. 0,1 mm, aufweisen, verhindert wird und somit das Verweilen des Biomakromoleküls an der gleichen Position während der gesamten Reaktion und des Analysevorgangs gewährleistet ist.

Von Vorteil ist dabei eine Weiterbildung nach den Ansprüchen 14 und 29, weil die Materialien resistent gegenüber organischen Lösungsmitteln, wie z.B. Azeton, Benzen, Acetonitril, Dioxan, 2,2,2 Triflouroethanol, sind. Des weiteren sind sie mit verschiedenen, häufig gebrauchten Salzen, Puffern und Polymeren, die für die Kristallisation verwendet werden, kompatibel. Polypropylen und Cycloolefin-Copolymere (COC) sind außerdem weniger permeabel für Wasserdampf und daher weniger sensitiv für die Verdunstung, als Behälter aus beispielsweise Polystyrol.

Von Vorteil ist weiters eine Ausgestaltung nach Anspruch 15, wonach durch den Einsatz verschiedener Kunststoffe für die Ausbildung des Behälters verschiedene Eigenschaften ermöglicht werden können. Beispielsweise müssen nur die Küvetten den Belastungen durch organische Lösungsmittel widerstehen können, allerdings ist diese Erfordernis für die Seitenwände nicht gegeben.

Gemäß Anspruch 16 wird eine einfache Orientierung während des Arbeitens mit dem Behälter ermöglicht. Des weiteren kann durch eine entsprechende Markierung des Behälters auch ein internes Kontrollsystem und Orientierungssystem für die automatisierte Bearbeitung eingearbeitet werden.

Vorteilhaft ist weiters eine Ausgestaltung nach Anspruch 17, wonach durch das ausgewählte Herstellungsverfahren eine rasche und kostengünstige Produktion des Behälters ermöglicht wird.

Dabei erweist sich eine Ausgestaltung nach Anspruch 18 vorteilhaft, wonach durch die standardisierten Abmessungen des Behälters eine Automatisierung der Arbeiten mit den Behältern ermöglicht wird. Durch die Möglichkeit der automatisierten Bearbeitung kann eine Vielzahl von Proben gleichzeitig analysiert werden. Durch die Anordnung der Küvetten nach dem SBS-Standard wird auch eine sehr hohe Dichte der Küvetten erreicht. Außerdem erweist sich von Vorteil, dass durch die Automatisierung ein gleichzeitiges Befüllen mehrerer Küvetten möglich ist. Vorteilhaft an dieser Ausgestaltung ist weiters, dass durch die standardisierte Anzahl der Küvetten, die für Befüllung- und Untersuchungseinrichtungen, wie sie für Mikrotiterplatten verwendet werden, auch für den erfindungsgemäßen Behälter verwendet werden können.

Eine Ausgestaltung nach Anspruch 19 erweist sich von Vorteil, wonach durch das Befüllen der Ausnehmung mit einer Flüssigkeit eine Verdunstung der Kristallisationsreagenzien und der hydrophoben Flüssigkeit reduziert werden kann, und dadurch die Konzentrationen dieser Reagenzien während des gesamten Reaktionsvorgangs und des Analysevorgangs konstant gehalten werden kann.

Weiters erweist sich eine Weiterbildung nach Anspruch 20 von Vorteil, wonach durch das Anbringen zumindest eines Halteelements die Einrichtung zur Unterteilung eines Volumens eines Behälters in Teilbereiche an einer vordefinierten Position angebracht werden muss und somit die Reproduzierbarkeit des Experiments einfacher ermöglicht wird.

Von Vorteil ist dabei eine Weiterbildung nach Anspruch 21, wonach eine erhöhte Stabilität der Einrichtung erzielt werden kann. Durch die erzielte erhöhte Stabilität kann die Einrichtung während des Experiments manipuliert werden. Des weiteren kann sie sogar nach gründlich erfolgter Reinigung mehrmals für unterschiedliche Experimente verwendet werden.

Durch die Weiterbildung nach Anspruch 22 kann erreicht werden, dass die Teilbereiche strömungsverbunden sind. Durch diese Strömungsverbindung kann im gesamten Behälter ein Ausgleich von Konzentrationsunterschieden zwischen den Teilbereichen erzielt werden und somit im gesamten Behälter die gleichen Reaktionsbedingungen gewährleistet werden.

Gemäß Anspruch 23 wird eine Konformität mit der Anordnung der Küvetten im Behälter erzielt, und somit die automatisierte Bearbeitung erleichtert.

Vorteilhaft erweist sich dabei eine Ausbildung nach Anspruch 24, wonach durch die ausreichende Beabstandung der Stege von der Aufstandsfläche eine ungehinderte Verteilung der hydrophoben Flüssigkeitsmenge über die gesamte Bodenplatte des Behälters ermöglicht wird, und dadurch die einzelnen Teilbereiche miteinander strömungsverbunden sind.

Dabei erweist sich eine Ausgestaltung nach Anspruch 25 von Vorteil, wonach durch das Anliegen der Stege an die Bodenplatte eine flüssigkeitsdichte Barriere für das hydrophobe Flüssigkeitsmittel geschaffen wird. Durch das Anliegen der Stege an die Bodenplatte kann somit ermöglicht werden, dass auf einer Bodenplatte viele verschiedene hydrophobe Flüssigkeitsmittel, wie z.B. Silikonöl oder Paraffinöl, bzw. viele verschiedene Verhältnisse der hydrophoben Flüssigkeitsmittel, beispielsweise Silikonöl zu Paraffinöl im Verhältnis 1:1, oder 1:2, oder 2:1, etc., zueinander ausgetestet werden können. Des weiteren erweist sich von Vorteil, dass durch die Entstehung der Teilbereiche Verdünnungsreihen verschiedener an der Reaktion beteiligter Reagenzien, beispielsweise der Präzipitationslösung, ausgetestet werden können Von Vorteil ist dabei eine Weiterbildung nach Anspruch 26, wonach durch die beabstandete Anordnung des Gitters zu den Seitenwänden ein leichteres Ein- und Ausfügen des Gitters in den Behälter ermöglicht wird. Weiters ist von Vorteil, dass durch die Anbringung der Abstandhalter, der Rahmen nicht exakt in den Behälter angepasst werden muss.

Vorteilhaft ist weiters eine Ausführung nach Anspruch 27, wonach eine einfachere Manipulation der Einrichtung, insbesondere eine leichteres Einfügen bzw. Herausnehmen aus dem Behälter, ermöglicht wird.

Vorteilhaft gemäß der Ausbildung nach Anspruch 1 ist, dass sowohl der Reagenzienverbrauch als auch der Biomakromolekülverbrauch minimiert werden kann. Weiters ist von Vorteil, dass durch den geringen Bedarf an Biomakromolekülen die Experimente mehrmals mit dem gleichen Ausgangsmaterial wiederholt werden können und dadurch eine neuerliche aufwendige Herstellung des Biomakromoleküls vermieden werden kann. Von Vorteil ist auch, dass mehrmals das gleiche Biomakromolekül eines Isolierungsvorganges verwendet werden kann, und somit Unterschiede im Analyseergebnis aufgrund von unterschiedlichen Isolationsbedingungen ausgeschlossen werden können.

Die Aufgabe der Erfindung wird eigenständig auch durch die Verwendung des Behälters entsprechend den Merkmalen im Kennzeichenteil des Anspruches 29 gelöst. Vorteilhaft darin ist, dass eine Vielzahl von Proteinen gleichzeitig unter den gleichen Bedingungen kristallisiert werden kann.

Die Aufgabe der Erfindung wird eigenständig auch durch die Verwendung der Einrichtung entsprechend den Merkmalen im Kennzeichenteil des Anspruches 30 gelöst. Vorteilhaft daran ist, dass die Einrichtung als Wellenbrecher für die hydrophobe Flüssigkeit dient. Von Vorteil erweist sich auch, dass durch die große Anzahl der Kristallistionsexperimente in kurzer Zeit ein Degradieren des Biomakromoleküls verhindert werden kann. Des weiteren können für ein Biomakromolekül mehrere unterschiedliche Kristallisationsbedingungen gleichzeitig ausgetestet werden.

Zum besseren Verständnis der Erfindung wird diese anhand der nachfolgenden Figuren näher erläutert, wobei diese in schematisch vereinfachter Darstellung einen Behälter zur Probenaufnahme zeigen.

Die Erfindung wird im nachfolgenden anhand der in den Zeichnungen dargestellten Ausführungsbeispiele näher erläutert.

Es zeigen:
- Fig. 1: einen Behälter zur Probenaufnahme mit 96 Küvetten;
- Fig. 2: einen Behälter zur Probenaufnahme mit 384 Küvetten;
- Fig. 3: einen Behälter mit 96 Küvetten mit Halteelement für eine Einrichtung;
- Fig. 4: einen Behälter mit 384 Küvetten mit Halteelement für eine Einrichtung;
- Fig. 5: eine Einrichtung zur Unterteilung eines Volumens mit seitlichen Abstandhalter angeordnet in einem 4 x 4 Raster;
- Fig. 6: eine Einrichtung zur Unterteilung eines Volumens mit seitlichen Abstandhalter angeordnet in einem 6 x 4 Raster;
- Fig. 7: eine Einrichtung mit zylindrischen Abstandhalter;
- Fig. 8: einen Schnitt einer Einrichtung mit plattenförmigen Abstandhalter;
- Fig. 9: einen Schnitt eine Einrichtung zur Unterteilung eines Volumens;
- Fig. 10: eine Draufsicht einer Kristallisationsvorrichtung;
- Fig. 11: eine Seitenansicht einer konischen Küvette mit halbkugeligem Boden;
- Fig. 12: eine Seitenansicht einer zylindrischen Küvette mit flachem Boden;
- Fig. 13: eine Seitenansicht einer zylindrischen Küvette mit halbkugeligem Boden;
- Fig. 14: eine Seitenansicht einer zylindrischen Küvette mit kegelförmigen Boden;
- Fig. 15: eine Seitenansicht einer konischen Küvette mit flachem Boden;
- Fig. 16: eine Seitenansicht einer konischen Küvette mit kegelförmigen Boden;
- Fig. 17: eine Prinzipdarstellung eines Verwendungsbeispiels einer Kristallisationsvorrichtung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Die Proteinkristallisation ermöglicht einen Zugang zur dreidimensionalen Struktur eines beliebigen Proteins. Außerdem ist sie auch in der Lage, die Lücke zwischen der genomischen und der Strukturinformation von Biomakromolekülen zu überbrücken. Nicht alleine das Vorhandensein des Proteins ist maßgebend für deren Funktion, sondern auch die Konformation. Die Struktur des Proteins gibt auch wichtige Informationen über die Interaktionen mit anderen Molekülen.

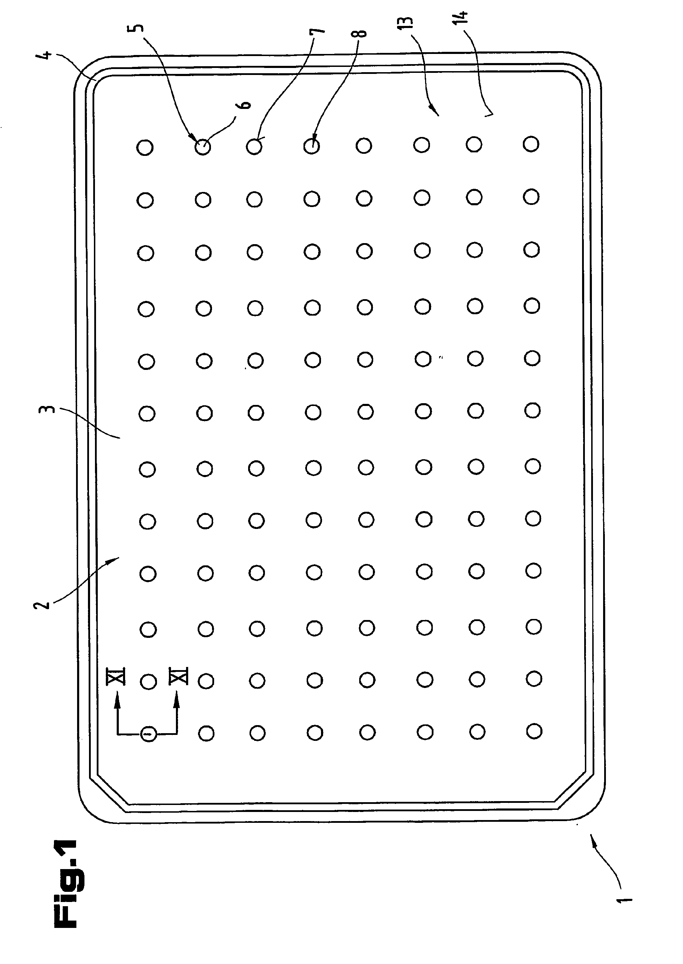

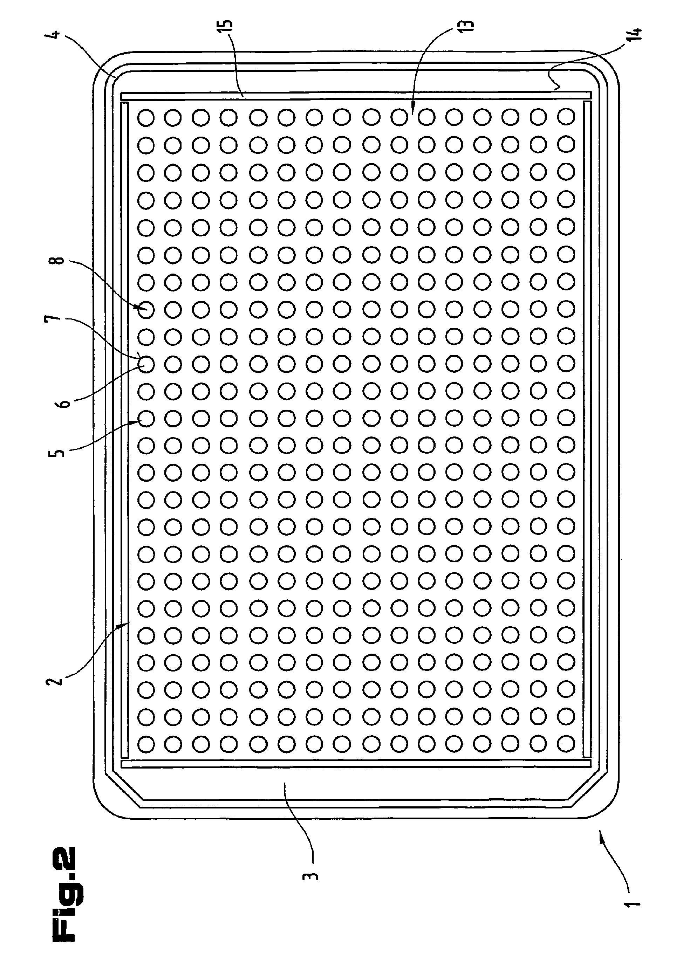

Die Fig. 1 und 2 zeigen eine Draufsicht auf einen Behälter 1 mit einem Grundkörper 2, bestehend aus einer Bodenplatte 3 und Seitenwände 4. Die Bodenplatte 3 besteht aus Küvetten 5, die vom Boden 6 und den Wänden 7 gebildet werden. Die Seitenwände 4 umschließen den Reaktionsbereich 8. Ein Behälter 1, wie in Fig. 1 und 2 beschrieben, ist für Versuchsdurchführungen, bei denen es besonders auf die Miniaturisierung ankommt, geeignet. So ist es z.B. möglich, eine größere Zahl von Küvetten 5 in einem dafür vorgesehenen Grundkörper 2 eines Behälters 1 anzuordnen um dadurch eine große Zahl von Reaktionsbereichen 8 gleichzeitig zu schaffen. Fig. 1 und 2 zeigen eine beispielhafte Anordnung von einer Vielzahl von Küvetten 5 in einem Behälter 1, die in Fig. 1 eine Anzahl von 96 Küvetten 5 und in Fig. 2 eine Anzahl von 384 Küvetten 5 umfasst. Der Grundkörper 2 des Behälters 1 ist gemäß einer Standardgröße einer Mikrotiterplatte ausgebildet und besitzt Abmessungen gemäß den Empfehlungen der SBS (Society of Biomolecular Screnning; www.SBSonline.org), wobei der Behälter 1 eine Gesamthöhe ausgewählt aus einem Bereich mit einer unteren Grenze von 6 mm, vorzugsweise 8 mm, insbesondere 10,4 mm, und einer oberen Grenze von 22 mm, vorzugsweise 16 mm, insbesondere 14,4 mm, aufweist.

Die Küvetten 5 sind in einem rechtwinkeligem Raster angeordnet. Dabei bilden jeweils benachbarte Küvetten 5, die jeweils ihnen eigens zugeordnete Wände 7 besitzen, voneinander getrennte und zueinander parallele Reihen. Diese Reihen sind parallel zur Längserstreckung des Behälters 1 ausgerichtet, wobei jeweils aufeinander folgende Reihen von Küvetten 5 in einem gleichen Abstand angeordnet sind. In einer alternativen Ausführungsvariante eines Behälters 1 können die Reihen aber auch normal zur Längserstreckung ausgerichtet sein.

Die Küvetten 5 sind in Reihen angeordnet. Der Begriff Reihe ist dabei stets in geometrischem Sinn als eine lineare Anordnung von zueinander gleichen Objekten zu verstehen, sodass jeweils gleichartige Punkte der Objekte auf einer gemeinsamen Geraden liegen. Die Küvetten 5 bilden einen Reaktionsbereich 8, wobei jeder Küvette 5 eine eigene Wand 7 zugeordnet ist. Bei sehr dichter Anordnung der Küvetten 5 kann eine Wand 7 benachbarten Küvetten 5 gemeinsam zugeordnet werden.

Die Seitenwände 4 der Bodenplatte 3 bilden mit ihrer Unterkante die Behälteraufstandsfläche. Die Böden 6 der Küvetten 5 sind in einer Ebene parallel zur Aufstandsebene angeordnet. Der Abstand des Bodens 6 der Küvetten 5 zur Oberfläche 14 der Bodenplatte 3 ist geringer als der Abstand der Unterkante der Seitenwände 4 des Behälters 1 zur Oberfläche 14 der Bodenplatte 3. Die Böden 6 der Küvetten 5 sind daher in einem Abstand ausgewählt aus einem Bereich mit einer unteren Grenze von 0,1 mm, insbesondere 0,3 mm, vorzugsweise 0,5 mm, und einer oberen Grenze von 7 mm, insbesondere 6 mm, vorzugsweise 5 mm, angeordnet. Als vorteilhaft haben sich auch Abstände ausgewählt aus einem Bereich mit einer unteren Grenze von 0,7 mm, insbesondere 1 mm, vorzugsweise 1,5 mm, und einer oberen Grenze von 4 mm, insbesondere 3 mm, vorzugsweise 2 mm, erwiesen.

In einer alternativen Ausführungsform kann die Bodenplatte 3 auf einer Ebene parallel zur Aufstandsebene, auf welcher auch der Boden 6 der Küvetten 5 angeordnet ist, liegen. Die Bodenplatte 3 und der Boden 6 der Küvetten 5 sind in dieser Variante auf derselben Ebene angeordnet. Die Oberkante der Wände 7 der Küvetten 5 liegt somit in einer Ebene parallel zur Aufstandsebene aber in einem größeren Abstand als die Ebene, in welche der Boden 6 der Küvetten 5 angeordnet ist.

Die Küvetten 5 haben im Reaktionsbereich 8 ein Fassungsvermögen von einem Volumen ausgewählt aus einem Bereich mit einer unteren Grenze von 0,01 µl, vorzugsweise 0,5 µl, insbesondere 0,1 µl, und einer oberen Grenze von 50 µl, vorzugsweise 10 µl, insbesondere 5 µl. Die Küvetten 5 haben einen Durchmesser, ausgewählt aus einem Bereich mit einer oberen Grenze von 10 mm, vorzugsweise 7 mm, insbesondere 5 mm und einer unteren Grenze von 0,1 mm, vorzugsweise 0,3 mm, insbesondere 0,5 mm. Besonders vorteilhaft haben sich Durchmesser, ausgewählt aus einem Bereich mit einer oberen Grenze von 4 mm, vorzugsweise 3 mm, insbesondere 2 mm und einer unteren Grenze von 0,6 mm, vorzugsweise 0,7 mm, insbesondere 0,9 mm, erwiesen. Die Höhe der Küvetten 5 ist aus einem Bereich mit einer unteren Grenze von 0,1 mm, vorzugsweise 0,2 mm, insbesondere 0,3 mm und einer oberen Grenze von 12 mm, vorzugsweise 10 mm, insbesondere 6 mm, ausgewählt. Besonders vorteilhaft haben sich Höhen der Küvetten, ausgewählt aus einem Bereich mit einer unteren Grenze von 0,5 mm, vorzugsweise 0,6 mm, insbesondere 0,8 mm und einer oberen Grenze von 5 mm, insbesondere 3 mm, vorzugsweise 2 mm, und besonders vorteilhaft von 1 mm, erwiesen.

Der Behälter 1 und die Küvetten 5 sind zur Aufnahme von Flüssigkeiten bzw. Lösungen bestimmt. Der Behälter 1 ist insbesondere zur Aufnahme von hydrophoben Flüssigkeiten 9 und die Küvetten 5 sind insbesondere zur Aufnahme des Tropfens 10, bestehend aus einem Biomakromolekül 11 kombiniert mit Kristallisationsreagenzien 12, und der hydrophoben Flüssigkeit 9 bestimmt. Das Reservoir 13 wird mit der hydrophoben Flüssigkeit 9 dermaßen befüllt, dass die hydrophobe Flüssigkeit 9 auch in die Küvetten 5 des Behälters 1 bei Verwendung des Behälters 1 in seiner Gebrauchslage gelangt. D.h. die gesamte Oberfläche 14 der Bodenplatte 3 des Behälters 1 ist somit mit der hydrophoben Flüssigkeit 9 bedeckt. Die Küvetten 5 sind zur Durchführung von Reaktionen, die zur Herstellung eines Kristalls aus in Kristallisationsreagenzien 12 gelösten Biomakromolekülen 11 dienen, bestimmt.

Die Oberfläche 14 der Bodenplatte 3 kann zwischen den Küvetten 5 mit einer hydrophoben Substanz , wie z.B. Fett, insbesondere Silikonfett, Öl, Polyethylenglykol, Polytetrafluorethylen, etc., oberflächenbehandelt sein. Alternativ kann auf die Oberfläche 14 der Bodenplatte 3 eine hydrophobe Maske aufgebracht sein, sodass sich im Reaktionsbereich 8 der Tropfen 10 befindet und zwischen den Reaktionsbereichen 8 die hydrophobe Flüssigkeit 9 vorhanden ist. Durch die hydrophoben Zwischenräume bleibt der Tropfen 10 während der gesamten Analyse an der selben Position des Behälters 1. Zusätzlich kann die Oberfläche 14 der Bodenplatte 3 zwischen den Reaktionsbereichen 8 eine mattierte Struktur aufweisen.

Der Behälter 1 wird im speziellen für die Kristallisation von Biomakromolekülen 11 unter einer hydrophoben Flüssigkeit 10, auch als "Microbatch-Methode" bekannt, verwendet. Kristallisation unter Öl ist eine Methode, wo ein kleiner Tropfen 10, bestehend aus einem Biomakromolekül 11 kombiniert mit Kristallisationsreagenzien 12, unter eine Ölschicht pipettiert wird. Das Verhältnis des Volumens des Biomakromoleküls 11 zu den dazu benötigten Kristallisationsreagenzien 12 befindet sich meist in einem Volumenverhältnis von 1:1 und der Tropfen 10 umfasst ein Gesamtvolumen von 1 µl bis 2 µl. Es können jedoch auch Tropfen 10 mit einem Volumen von bis zu 5 µl in die Küvetten 5 pipettiert werden. Die am häufigst verwendeten hydrophoben Flüssigkeiten 9 sind Paraffinöl oder Silikonöl oder ein Gemisch aus diesen beiden Ölen, meist im Verhältnis von 1:1. Es können aber auch andere Verhältnisse von Paraffinöl zu Silikonöl verwendet werden, um die Diffusionsrate des Tropfens zu verändern (je höher der Prozentanteil des Silikonöls ist, um so rascher erfolgt die Diffusion und die Verdunstung).

Wahlweise kann das Material für die Bildung des Bodens 6 der Küvetten 5 lichtdurchlässig und die Bodenplatte 3 kann aus einem lichtundurchlässigen bzw. lichtabschirmenden Material gebildet bzw. mit einer lichtundurchlässigen bzw. lichtabschirmenden Schicht versehen werden. Durch die lichtabschirmende Wirkung wird störende Einflüsse von Streulicht bei der optischen Beobachtung des Reaktionsablaufs in den Reaktionsbereichen 8 verhindert. Der Behälter 1 kann selbstverständlich auch gesamt von einem lichtdurchlässigen bzw. lichtundurchlässigen Kunststoff gebildet werden.

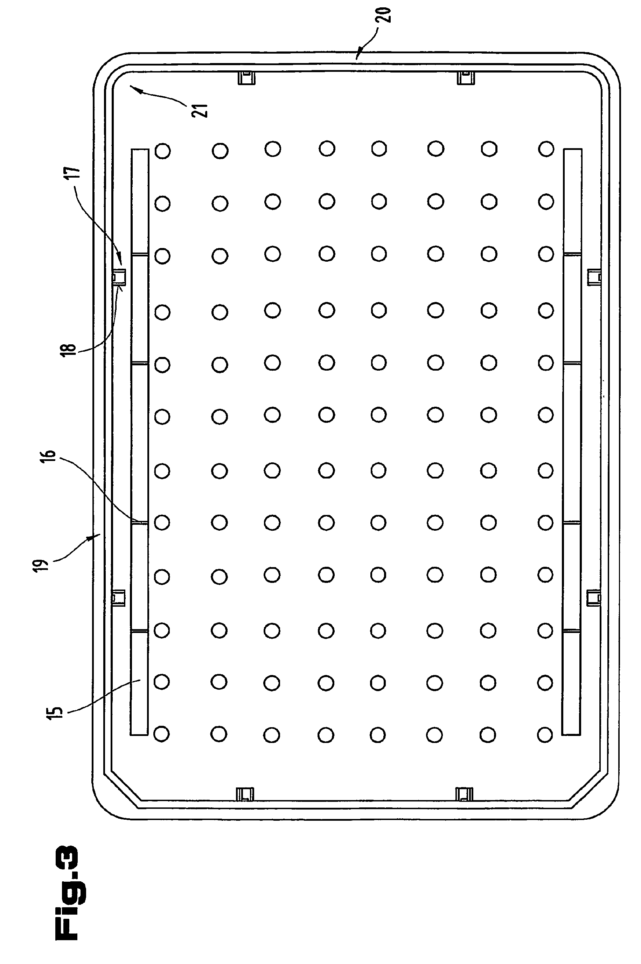

Die Fig. 2 und 3 zeigen Ausnehmungen 15, die sowohl an der Längsseite 19 als auch an der Querseite 20 des Grundkörpers 2 bzw. entweder an der Längsseite 19 oder an der Querseite 20 angeordnet sein können. Die Ausnehmung 15 kann zusätzlich durch Trennwände 16 in mehrere kleinere Teilbereiche unterteilt werden. Die Ausnehmungen dienen zur Aufnahme von Flüssigkeiten, wobei sich in jedem Teilbereich beispielsweise verschiedene Flüssigkeiten oder unterschiedliche Konzentrationen der gleichen Flüssigkeit befinden können, welche eine Verdunstung der Kristallisationsreagenzien 12 bzw. der hydrophoben Flüssigkeit 9 verhindern bzw. minimieren. Die Oberkante der Begrenzungen der Ausnehmungen 15 liegt auf derselben Ebene wie die Oberkante der Wände 7 der Küvetten 5. Alternativ kann die Oberkante der Ausnehmung 15 auch in einer parallelen Ebene, allerdings in einem größeren Abstand als die Ebene der Oberkante der Wände 7 der Küvetten 5 zur Aufstandsebene, angeordnet sein.

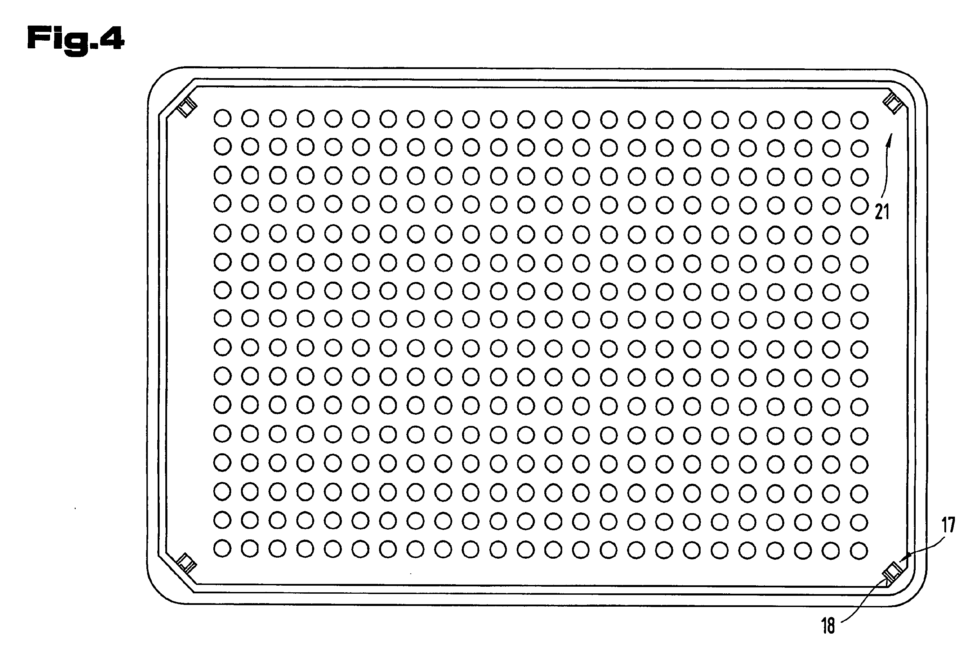

Die Fig. 3 und 4 zeigen Halteelemente 17, angeordnet an den Seitenwänden 4, eines erfindungsgemäßen Behälters 1. Die Halteelemente 17 bestehen aus zwei Seitenteilen 18, die wahlweise auch mit der Bodenplatte 3 verbunden sein können. Die Seitenteile 18 sind beabstandet angeordnet, sodass ein Abstandhalter 26 einer Einrichtung 22 zwischen die beiden Seitenteile 18 des Halteelements 17 eingeführt werden kann. Die Halteelemente 17 können sowohl an der Längsseite 19 als auch an der Querseite 20 der Seitenwände 4 des Behälters 1 angeordnet sein. Außerdem ist es auch möglich, die Halteelement 17 in den Ecken 21 des Behälters 1 anzuordnen. Ein Halteelement 17 der Einrichtung 22 zur Unterteilung eines Volumens verhindert, dass die Einrichtung 22 während möglicher Bewegungen des Behälters 1 während der Bearbeitung unbeabsichtigt verrutscht. Die Halteelemente 17 an den Seitenwänden 4 des Grundkörpers 2 können in beliebiger Anzahl vorhanden sein. In der Fig. 3 werden beispielsweise acht Halteelemente 17 dargestellt, wobei jeweils zwei Halteelemente 17 an einer Längs-19 bzw. Querseite 20 des Grundkörpers 2 angeordnet sind. In Fig. 4 werden vier Halteelemente 17, die jeweils in den Ecken 21 des Grundkörpers 2 angeordnet sind, dargestellt. Die Abstandhalter 25, die am Rahmen 24 der Einrichtung 22 angeordnet sind, werden in die Halteelemente 17 an den Seitenwänden 4 oder die Bodenplatte 3 des Behälters 1 eingeführt. Die Einrichtung 22 ist dadurch flexibel und kann jederzeit entfernt bzw. für weitere Analysen verwendet werden. In einer alternativen Ausführungsvariante kann die Einrichtung 22 auch an den Seitenwänden 4 oder der Bodenplatte 3 des Behälters 1 ohne Halteelemente 17, beispielsweise durch Verkleben, montiert sein. Diese Anordnungen der Halteelemente 17 sollen nur eine beispielhafte Ausführung der Halteelementanordnung zeigen. Selbstverständlich kann auch jede beliebige andere Anordnung von Halteelementen 17 ausgewählt werden.

Die Anzahl der Küvetten 5 im Grundkörper 2 kann aus einer Gruppe ausgewählt sein, die die Zahlen, gebildet durch die mathematische Formel 3 x 2ⁿ, wobei n eine natürliche Zahl ist, umfasst. Es können selbstverständlich auch Behälter 1 mit einer anderen als einer Standardgröße von Mikrotiterplatten entsprechenden Anzahl von Küvetten 5, wie z.B. 24, 48 96, 384, 1536 etc. hergestellt werden.

Die Küvetten 5 haben in Draufsicht eine kreisförmige Grundfläche. In der Anordnung der Küvetten 5, wie in Fig. 1 bis 4 dargestellt, wird das zur Verfügung stehende Volumen bzw. die zur Verfügung stehende Grundfläche der Bodenplatte 3 sehr effizient ausgenutzt. Selbstverständlich ist es auch möglich, die Grundfläche der Küvetten 5 rechteckig, quadratisch oder in Form eines Parallelogramms auszubilden. Es ist auch möglich, die zueinander parallelen Reihen der Küvetten 5 gegeneinander in Richtung der Längserstreckung des Behälters 1 versetzt anzuordnen. In einer anderen Ausführungsform ist es auch möglich, die Küvetten 5 mit regelmäßig sechseckigen Querschnitt auszubilden und die Küvetten 5 bienenwabenartig anzuordnen. Für die automatisierte Bearbeitung des Behälters 1 mit standardisierten Laborrobotem eignet sich eine Anordnung der Küvetten 5 mit kreisförmiger Grundfläche in Reihen am besten.

Der Behälter 1 ist bevorzugt aus Polystyrol oder COC gefertigt. Selbstverständlich kann der Behälter 1 auch aus einem anderen Werkstoff hergestellt werden, bevorzugt Kunststoffe, die sich für die Formgebung mit Spritzgusstechnik eignen, wie z.B. Polypropylen, Acrylbutadienstyrol, Polyamid, Polycarbonat, Polymethylmethacrylat, Polysulfon und/oder Styrolacrylnitril, etc. Es kann auch eine Kombination von zwei oder mehr Materialien bzw. verschiedenen Kunststoffen verwendet werden, wobei beispielsweise für die Küvetten 5, COC und für die Bildung der Bodenplatte 3, Polystyrol verwendet wird. In einer alternativen Ausführungsform werden die Bodenplatte 3 und die Küvetten 5 aus COC und die Seitenwände 4 aus Polystyrol gebildet.

In der Bodenplatte 3 des Grundkörpers 2 bzw. an den Seitenwänden 4 können Markierungen zur Koordinatenerkennung des Behälters angegeben sein. Die Markierungen können sowohl optisch sichtbar sein, als auch nur durch geringfügige Veränderungen der Oberfläche 14 markiert sein, die von einem automatischen Labormanipulationssystem erkannt werden können.

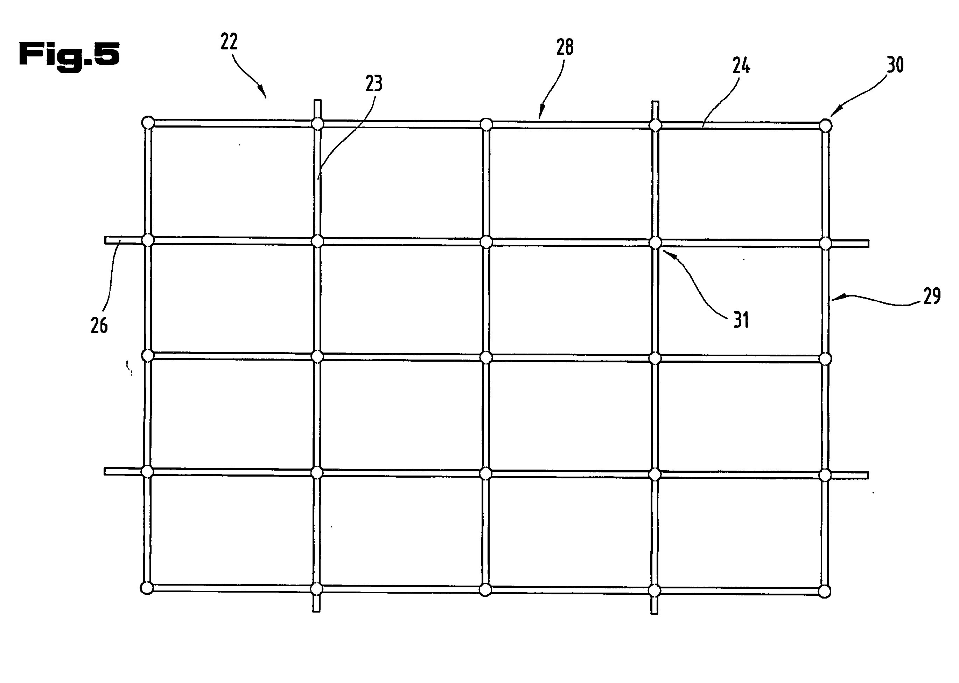

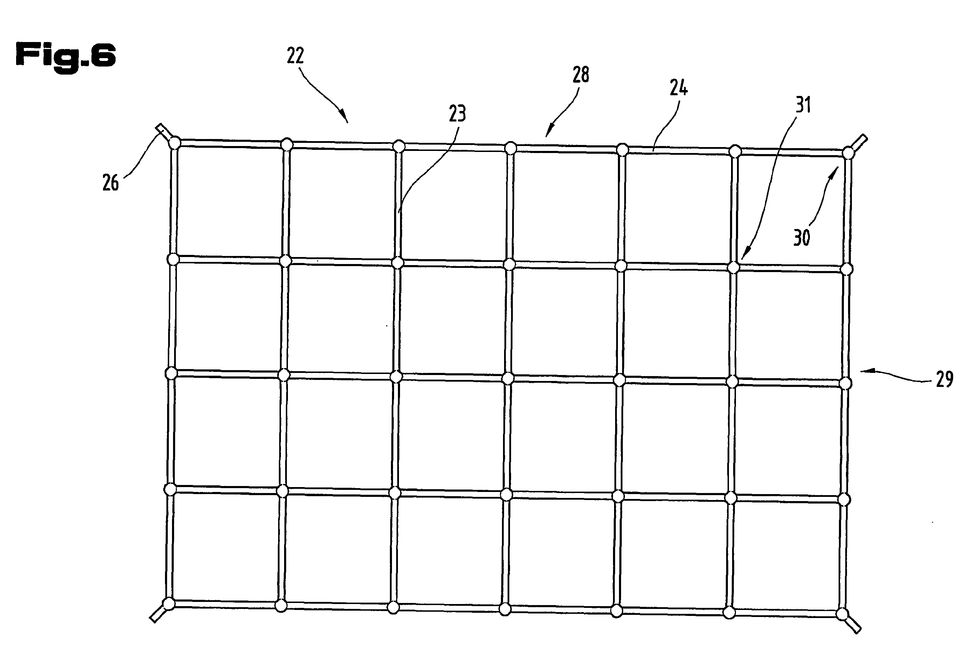

Fig. 5 und 6 zeigen in Draufsicht eine Einrichtung 22 zur Unterteilung eines Volumens in Teilbereiche, wobei die Einrichtung 22 von zueinander rechtwinkelig angeordneten Stegen 23 gebildet wird. Wahlweise kann die Anordnung der Stege 23 auch in einem anderen geometrischen Muster, z.B. hexagonal, octogonal, etc., erfolgen. Zur Stabilitätsverbesserung können die Stege 23 von einem Rahmen 24 umgeben sein. Die Anzahl der Stege 23 ist variabel. So kann beispielsweise wie in Fig. 5 die Einrichtung 22 mit 16 Unterteilungen oder wie in Fig. 6 mit 24 Unterteilungen, ausgebildet sein. Selbstverständlich kann die erfindungsgemäße Einrichtung 22 auch jede beliebige andere Anzahl an Unterteilungen aufweisen.

Am Rahmen 24 der Einrichtung 22 können zur Anordnung in einem Behälter 1 untere 25 und seitliche 26 Abstandhalter angeordnet sein. Die unteren Abstandhalter 25 sind an der Unterkante 27 der Stege 23 bzw. des Rahmens 24 angeordnet. Die seitlichen Abstandhalter 26 sind jeweils an der Längs- 28, Querseite 29 und/oder den Ecken 30 der des Rahmens 24 der Einrichtung 22 angeordnet. In Fig. 5 ist beispielhaft dargestellt, dass an jeder Längs- 28 und Querseite 29 jeweils zwei seitliche Abstandhalter 26 angeordnet sind. Fig. 6 zeigt eine alternative Anordnung der seitlichen Abstandhalter 26 an den Ecken 30 des Rahmens 24 der Einrichtung 22.

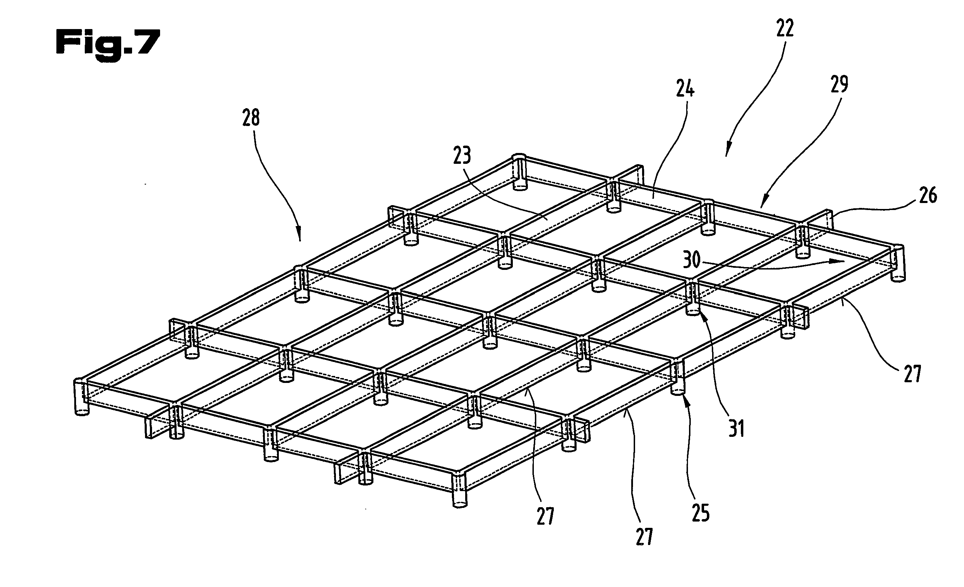

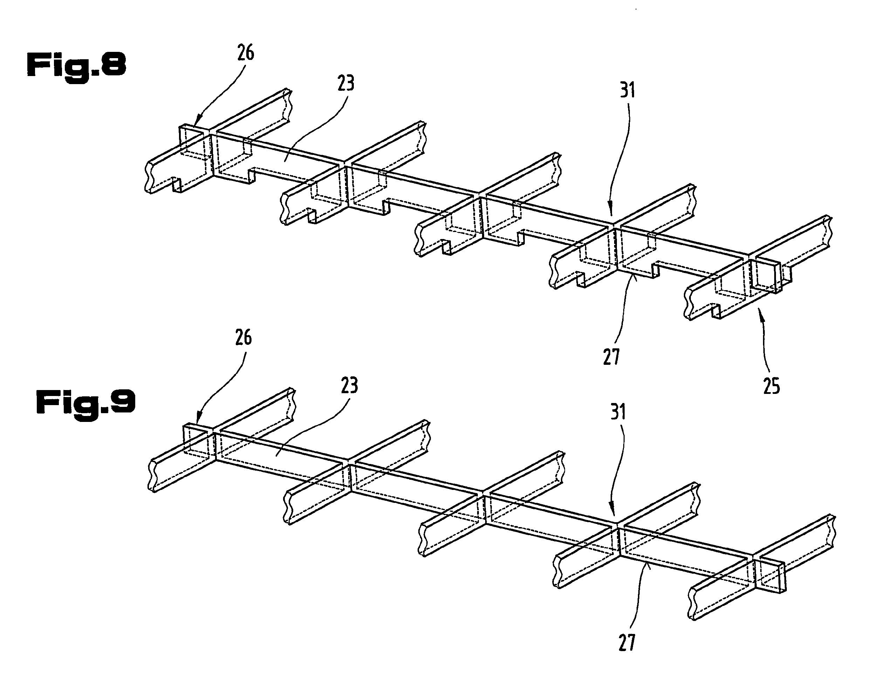

Fig. 7 zeigt eine perspektivische Ansicht unterer Abstandhalter 25 zur Bodenplatte 3 einer erfindungsgemäßen Einrichtung 22. Die Abstandhalter 25 können in den Kreuzungsbereichen 31 der Stege 23 angeordnet sein bzw. an den Stegen 23 zwischen den Kreuzungsbereichen 31. Die Abstandhalter 25, 26 können zylindrisch (Fig. 7), plattenförmig (Fig. 8), etc. ausgebildet sein. Die Stege 23 bzw. der Rahmen 24 weisen im Bereich, wo sie als Abstandhalter fungieren, eine um ein Drittel bis zur Hälfte größere Höhe als in den Bereichen wo sie nicht als Abstandhalter fungieren. Durch die beabstandete Halterung der Einrichtung 22 im Grundkörper 2 wird es ermöglicht, dass die hydrophobe Flüssigkeit 9, die sich im Behälter 1 befindet, gleichmäßig über die gesamte Bodenplatte 3 verteilt wird. Durch die Verwendung der Einrichtung 22 wird erzielt, dass sich Bewegungen der hydrophoben Flüssigkeit 9 bei Erschütterungen des Behälters 1 nicht mit gleicher Intensität über die gesamte Bodenplatte 3 ausbreiten, weil die Einrichtung 22 als Wellenbrecher fungiert.

In Fig. 9 wird ein Schnitt durch eine Einrichtung 22 gezeigt, in welcher die Stege 23 der Einrichtung 22 durchgehend bis zur Bodenplatte 3 ausgebildet sind. Es können dadurch viele verschiedene separat gebildete Reaktionsräume 33 geschaffen werden. Die hydrophobe Flüssigkeit 9, die jeder Küvette 5 zugeordnet ist, kann dadurch in jedem Reaktionsraum 33 in jeweils einer anderen Zusammensetzung bzw. Konzentration verwendet werden. Beispielsweise wird es dadurch ermöglicht eine Verdünnungsreihe der Kristallisationsreagenzien 12, der Biomakromoleküle 11 und/oder der hydrophoben Flüssigkeit 9 auszutesten. In dieser Ausführungsvariante ist die Außenabmessung der Einrichtung 22 geringfügig kleiner oder gleich groß wie die Abmessung des Behälters 1.

Die Einrichtung 22 kann auch mit den seitlichen Abstandhaltern 26 auf die Seitenwände 4 des Grundkörpers 2 aufgesetzt werden. Die unteren Abstandhalter 25 ragen daher nur in das Reservoir 13 des Behälters 1. Die Stege 23 bzw. der Rahmen 24 weisen bei dieser Ausführungsvariante im Bereich, wo sie als Abstandhalter fungieren, eine um mehr als ein Drittel bis zur Hälfte größere Höhe als in den Bereichen, wo sie nicht als Abstandhalter fungieren, auf. Bei dieser Ausführungsvariante sind die Außenabmessungen der Einrichtung 22 zumindest gleich groß oder größer wie die Abmessungen des Behälters 1.

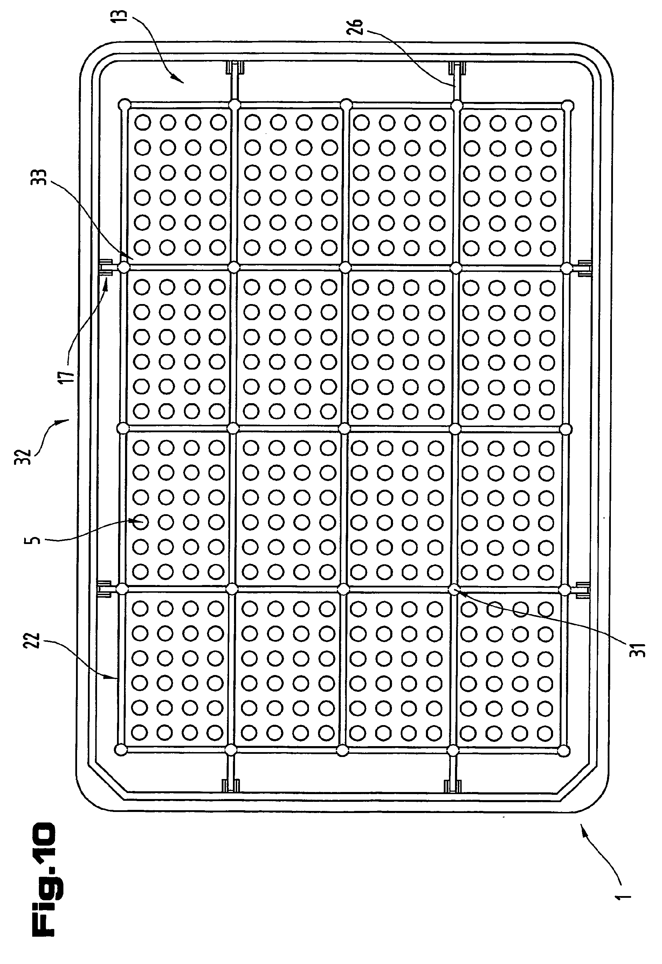

Fig. 10 zeigt eine Draufsicht auf eine Kristallisationsvorrichtung 32, bestehend aus einem Behälter 1 und einer Einrichtung 22 zur Unterteilung eines Volumen in zusammengebautem Zustand.

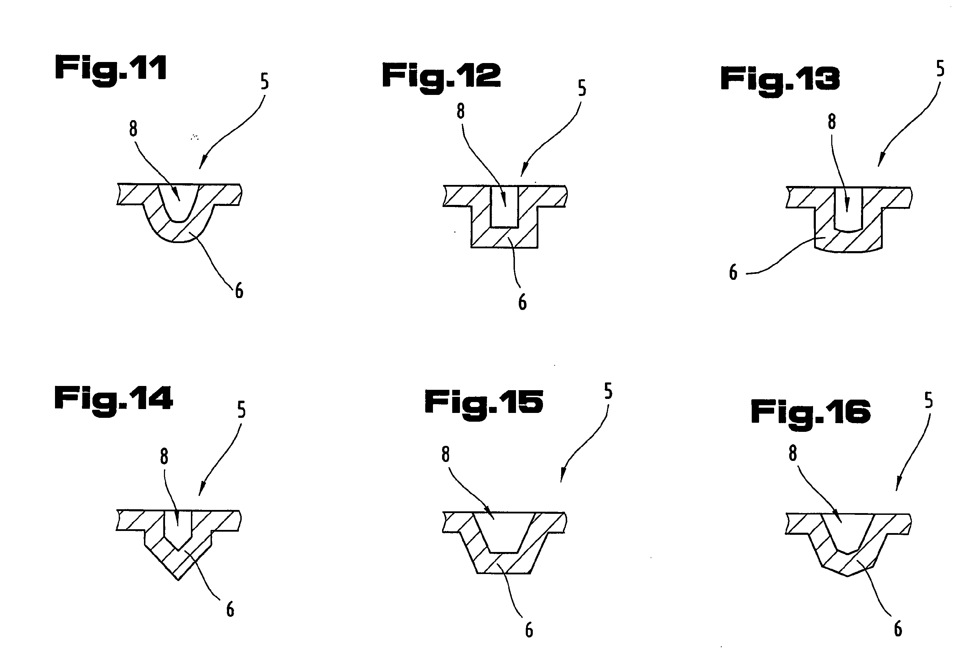

In den Fig. 11 bis 16 sind verschiedene Ausführungsvarianten der Ausgestaltung der Küvetten 5 in Seitenansicht dargestellt. Die Böden 6 der Küvetten 5 können zumindest annähernd konkav gekrümmt sein, d.h. die Böden 6 bzw. die Bodenbereiche der Küvetten 5 können durch Erweiterungen der Küvetten 5 in der Form eines Kegels, eines Kegelstumpfes oder eines Kugelabschnittes oder Kombination solcher Körper ausgebildet sein. Durch derart ausgebildete Reaktionsbereiche 8 wird die Deposition des Tropfens 10 unterstützt. Der Boden 6 der Küvetten 5 kann aus einem durchsichtigen Werkstoff bestehen, sodass das Kristallwachstum im Reaktionsbereich 8 ohne Manipulation beobachtet werden kann.

Fig. 11 zeigt eine Seitenansicht einer konischen Küvette 5 mit halbkugeligem Boden 6.

Fig. 12 stellt eine Seitenansicht einer zylindrischen Küvette 5 mit flachem Boden 6, Fig. 13 eine Seitenansicht einer zylindrischen Küvette 5 mit halbkugeligem Boden 6 und Fig. 14 eine Seitenansicht einer zylindrischen Küvette 5 mit kegelförmigen Boden 6 dar. Fig. 15 zeigt eine Seitenansicht einer konischen Küvette 5 mit flachem Boden 6 und Fig. 16 zeigt eine Seitenansicht einer konischen Küvette 5 mit kegelförmigen Boden 6.

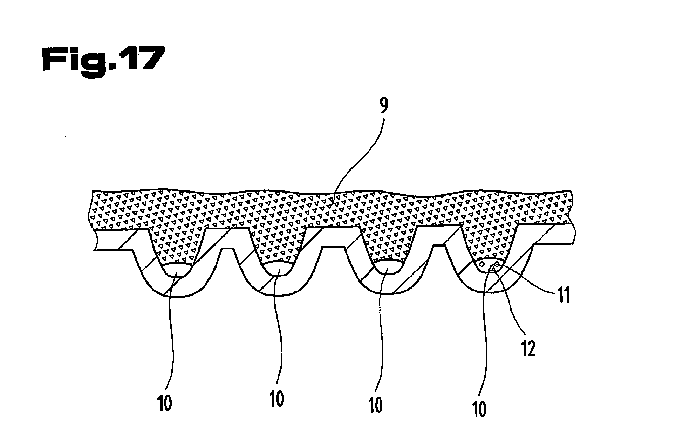

Fig. 17 zeigt eine Prinzipdarstellung der erfindungsgemäßen Verwendung der Kristallisationsvorrichtung 32 mittels Microbatch-Methode. In den Reaktionsbereich 8 der Küvetten 5 des Behälters 1 ist ein Tropfen 10 mit Biomakromolekülen 11 und Kristallisationsreagenzien 12 gefüllt, während sich im Behälter 1 bzw. in den Küvetten 5 die hydrophobe Flüssigkeit 9 befindet. In den Küvetten 5 kann zwischen dem Tropfen 10 und der hydrophoben Flüssigkeit 9 eine Diffusion stattfinden. Die Reaktionsverläufe in den Küvetten 5 können mit einem Mikroskop beobachtet werden. Ein Beispiel für eine Reaktion, die in einem Behälter 1 durchgeführt werden kann, ist die Herstellung eines Kristalls aus in Kristallisationsreagenzien 12 gelösten Biomakromolekülen 11, wie bereits in der Beschreibung ausgeführt wurde. Es wird eine geringe Menge an Biomakromolekülen 11, kombiniert mit Kristallisationsreagenzien 12 unter eine Schicht einer hydrophoben Flüssigkeit 9 pipettiert. Wichtig bei diesem Verfahren ist es, dass die Reagenzien, die in die Kristallisation involviert sind, in einer spezifischen Konzentration vorliegen und keine signifikanten Konzentrationsverschiebungen des Biomakromoleküls 11 noch der Kristallisationsreagenzien 12 im Tropfen 10 auftreten. Durch die Veränderung der hydrophoben Flüssigkeit 9, beispielsweise Paraffinöl und/oder Silikonöl, bzw. dem Verhältnis der an der Bildung der hydrophoben Flüssigkeit 9 beteiligten Substanzen, kann eine Konzentrationsverschiebung im Tropfen 10 durch Diffusion von Wasser durch das Öl eintreten. Dadurch wird eine Konzentrationssteigerung des Biomakromoleküls 11 und der Kristallisationsreagenzien 12 unter der hydrophoben Flüssigkeit 9 erzielt. Durch diese Konzentrationsverschiebung kommt es zur Ausbildung von Kristallen, insbesondere von Einkristallen. Die im Tropfen 10 gebildeten Kristalle können mit Hilfe eines Detektionssystems beobachtet bzw. detektiert werden.

Der Behälter 1 kann wahlweise auch mit einer Gefäßabdeckung versehen sein. Diese Gefäßabdeckung kann sowohl aus dem gleichen Material wie der Behälter 1 als auch aus einem anderen Kunststoff hergestellt werden. Außerdem kann zur Abdeckung des Behälters 1 auch eine Folie verwendet werden. Diese Folie kann an den Seitenwänden 4 des Behälters 1 angeklebt werden. Weiters kann diese Folie auch mit den Stegen 23 der Einrichtung in Verbindung treten.

Der Ordnung halber sei abschließend darauf hingewiesen, dass zum besseren Verständnis des Aufbaus des Behälters 1 diese bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

Vor allem können die einzelnen in den Fig. 1, 2, 3, 4, 5, 6, 7, 8, 9, 10, 11, 12, 13, 14, 15, 16, 17 gezeigten Ausführungen den Gegenstand von eigenständigen, erfindungsgemäßen Lösungen bilden. Die diesbezüglichen erfindungsgemäßen Aufgaben und Lösungen sind den Detailbeschreibungen dieser Figuren zu entnehmen.

### Bezugszeichenaufstellung

- 1: Behälter
- 2: Grundkörper
- 3: Bodenplatte
- 4: Seitenwand
- 5: Küvette

- 6: Boden
- 7: Wand
- 8: Reaktionsbereich
- 9: hydrophobe Flüssigkeit
- 10: Tropfen

- 11: Biomakromolekül
- 12: Kristallisationsreagens
- 13: Reservoir
- 14: Oberfläche
- 15: Ausnehmung

- 16: Trennwand
- 17: Halteelement
- 18: Seitenteil
- 19: Längsseite
- 20: Querseite

- 21: Ecke
- 22: Einrichtung
- 23: Steg
- 24: Rahmen
- 25: Abstandhalter (unten)

- 26: Abstandhalter (seitlich)
- 27: Unterkante
- 28: Längsseite der Einrichtung
- 29: Querseite der Einrichtung
- 30: Ecke der Einrichtung

- 31: Kreuzungsbereich
- 32: Kristallisationsvorrichtung
- 33: Reaktionsraum

## Patentansprüche

1. Behälter mit einem Grundkörper bestehend aus einer Bodenplatte und von dieser zumindest annähernd senkrecht abstehenden Seitenwänden und mit im Grundkörper angeordneten Küvetten, die als Vertiefung in der Bodenplatte (3) ausgebildet sind, wobei die Seitenwände (4) der Bodenplatte (3) in zumindest annähernd entgegengesetzter Richtung zu den Vertiefungen zur Aufnahme eines Volumens angeordnet sind, **dadurch gekennzeichnet, dass** eine gitterförmige Einrichtung (22) zur Unterteilung des Volumens in Teilbereiche angeordnet ist.

2. Behälter nach Anspruch 1, **dadurch gekennzeichnet, dass** die Küvetten (5) in einem gleichmäßigen Raster angeordnet sind.

3. Behälter nach Anspruch 1 oder 2, **dadurch gekennzeichnet, dass** 6, 12, 24, 48, 96, 384 oder 1536 Küvetten (5) angeordnet sind.

4. Behälter nach einem der Ansprüche 1 bis 3, **dadurch gekennzeichnet, dass** die Küvetten (5) konisch oder zylindrisch ausgebildet sind.

5. Behälter nach einem der Ansprüche 1 bis 4, **dadurch gekennzeichnet, dass** die Küvetten (5) ein Fassungsvermögen ausgewählt aus einem Bereich mit einer unteren Grenze von 0,01 µl, vorzugsweise 0,5 µl, insbesondere 0,1 µl, und einer oberen Grenze von 50 µl, vorzugsweise 10 µl, insbesondere 5 µl, aufweisen.

6. Behälter nach einem der Ansprüche 1 bis 5, **dadurch gekennzeichnet, dass** die Böden (6) der Küvetten (5) in einer zu einer Behälteraufstandsfläche parallelen Ebene angeordnet sind.

7. Behälter nach einem der Ansprüche 1 bis 6, **dadurch gekennzeichnet, dass** die Bodenplatte (3) bzw. die Küvetten (5) zur Ausbildung von Biomakromolekülen (11) besonders oberflächenbehandelt sind.

8. Behälter nach einem der Ansprüche 1 bis 7, **dadurch gekennzeichnet, dass** die Küvetten (5) mit Aldehyd, Silan, Epoxy, Thiol, Polyehtylenglycol (PEG), Polyoxyethylen-Sorbitan-Monolaureat, magnetischen Materialien, Streptavidin oder Biotin oberflächenbehandelt sind.

9. Behälter nach einem der Ansprüche 1 bis 8, **dadurch gekennzeichnet, dass** die Küvetten (5) in Seitenansicht quadratisch, rechteckig, kegelförmig oder halbkugelförmig ausgebildet sind.

10. Behälter nach einem der Ansprüche 1 bis 9, **dadurch gekennzeichnet, dass** die Küvetten (5) in Draufsicht rund, viereckig, wie z.B. quadratisch, rechteckig, hexagonal, octogonal oder in Form eines Parallelogramms ausgebildet sind.

11. Behälter nach einem der Ansprüche 1 bis 10, **dadurch gekennzeichnet, dass** die Küvetten (5), insbesondere der Boden der Küvetten, zumindest teilweise aus einem transparenten Kunststoff ausgebildet sind.

12. Behälter nach einem der vorhergehenden Ansprüche, **dadurch gekennzeichnet, dass** die Bodenplatte (3), insbesondere zwischen den Küvetten (5), zumindest teilweise lichtundurchlässig ausgebildet ist.

13. Behälter nach einem der vorhergehenden Ansprüche, **dadurch gekennzeichnet, dass** die Oberfläche (14) der Bodenplatte (3), insbesondere zwischen den Küvetten (5), mit einer hydrophoben Substanz oberflächenbehandelt oder eine hydrophobe Maske aufgebracht ist.

14. Behälter nach einem der vorhergehenden Ansprüche, **dadurch gekennzeichnet, dass** der Grundkörper (2) aus einem Material ausgewählt aus einer Gruppe umfassend Polypropylen, Polystyrol, Acrylbutadienstyrol, Polyamid, Polycarbonat, Polymethylmethacrylat, Polysulfon, Cycloolefin-Copolymer, Polymethylpenten und/oder Styrolacrylnitril gebildet ist.

15. Behälter nach einem der vorhergehenden Ansprüche, **dadurch gekennzeichnet, dass** der Grundkörper (2) aus mehreren verschiedenen Materialien ausgebildet ist.

16. Behälter nach einem der vorhergehenden Ansprüche, **dadurch gekennzeichnet, dass** eine Koordinatenerkennung für die Anordnung der Küvetten (5) an der Bodenplatte (3) angeordnet ist.

17. Behälter nach einem der vorhergehenden Ansprüche, **dadurch gekennzeichnet, dass** der Grundkörper (2) vorzugsweise mittels Spritzgussverfahren hergestellt ist.

18. Behälter nach einem der vorhergehenden Ansprüche, **dadurch gekennzeichnet, dass** an der Längsseite (19) und/oder an der Querseite (20) des Grundkörpers (2) eine Ausnehmung (15) angeordnet ist.

19. Behälter nach einem der vorhergehenden Ansprüche, **dadurch gekennzeichnet, dass** der Grundkörper (2) Abmessungen gemäß den Empfehlungen der SBS (Society of Biomolecular Screening) aufweist.

20. Behälter nach einem der vorhergehenden Ansprüche, **dadurch gekennzeichnet, dass** an den Seitenwänden (4) des Behälters (1) zumindest ein Halteelement (17) für eine Einrichtung (22) zur Unterteilung eines Volumens eines Behälters (1) in Teilbereiche vorhanden ist.

21. Behälter nach einem der Ansprüche 1 bis 20, **dadurch gekennzeichnet, dass** die Stege (23) der Einrichtung (22) außen von einem Rahmen (24) umgeben sind.

22. Behälter nach einem der Ansprüche 1 bis 21, **dadurch gekennzeichnet, dass** an der Unterseite der Einrichtung (22) Abstandhalter (25) zur Strömungsverbindung der Teilbereiche angeordnet sind.

23. Behälter nach einem der Ansprüche 1 bis 22, **dadurch gekennzeichnet, dass** die Stege (23) der Einrichtung (22) rechtwinkelig zueinander angeordnet sind.

24. Behälter nach einem der Ansprüche 1 bis 23, **dadurch gekennzeichnet, dass** die Einrichtung (22) in den Kreuzungsbereichen (31) der Stege (23) bzw. der Stege (23) mit dem Rahmen (24) eine um ein Drittel bis zur Hälfte größere Höhe als zwischen den Kreuzungsbereichen (31) aufweist.

25. Behälter nach einem der Ansprüche 1 bis 24, **dadurch gekennzeichnet, dass** die Stege (23) und/oder der Rahmen (24) der Einrichtung (22) die gleiche Höhe aufweisen.

26. Behälter nach einem der Ansprüche 1 bis 25, **dadurch gekennzeichnet, dass** der Rahmen (24) Abstandhalter (26) zur beabstandeten Halterung der Einrichtung (22) zu den Seitenwänden (4) des Behälters (1) aufweist.

27. Behälter nach einem der Ansprüche 1 bis 26, **dadurch gekennzeichnet, dass** die Au-βenabmessungen der Einrichtung (22) geringfügig kleiner als die Abmessungen des Behälters (1) sind.

28. Behälter nach einem der Ansprüche 1 bis 27, **dadurch gekennzeichnet, dass** die Einrichtung (22) aus einem Material ausgewählt aus einer Gruppe umfassend Polypropylen, Polystyrol, Acrylbutadienstyrol, Polyamid, Polycarbonat, Polymethylmethacrylat, Polysulfon, Cycloolefin-Copolymer, Polymethylpenten und/oder Styrolacrylnitril gebildet ist.

29. Verwendung des Behälters (1) nach einem der Ansprüche 1 bis 28 zur Kristallisation von Biomakromolekülen (11) in einem Kristallisationsreagens (12) in bzw. unter einer hydrophoben Flüssigkeit (9).

30. Verwendung des Behälters (1) mit der Einrichtung (22) nach einem der Ansprüche 1 bis 28 zur Abschwächung der Wellen eines bewegten Volumens in einem Behälter.

## Claims

1. Container with a base body consisting of a base plate and side walls standing up therefrom in an at least almost perpendicular arrangement, and having wells disposed in the base body in the form of a recess in the base plate (3), and the side walls (4) of the base plate (3) are disposed in at least the substantially opposite direction from the recesses in order to accommodate a volume, **characterised in that** a lattice-shaped unit (22) is provided in order to sub-divide the volume into part-regions.

2. Container as claimed in claim 1, **characterised in that** the wells (5) are arranged in a uniform pattern.

3. Container as claimed in claim 1 or 2, **characterised in that** there are 6, 12, 24, 48, 96, 384 or 1536 wells (5).

4. Container as claimed in one of claims 1 to 3, **characterised in that** the wells (5) are of a conical or cylindrical design.

5. Container as claimed in one of claims 1 to 4, **characterised in that** the wells (5) have a capacity selected from a range with a lower limit of 0.01 µl, preferably 0.5 µl, in particular 0.1 µl, and an upper limit of 50 µl, preferably 10 µl, in particular 5 µl.

6. Container as claimed in one of claims 1 to 5, **characterised in that** the bases (6) of the wells (5) are disposed in a plane parallel with the container support surface.

7. Container as claimed in one of claims 1 to 6, **characterised in that** the base plate (3) and the wells (5) are specifically surface-treated for producing bio-macro molecules (11).

8. Container as claimed in one of claims 1 to 7, **characterised in that** the wells (5) are surface-treated with aldehyde, silane, epoxy, thiol, polyethylene glycol (PEG), polyoxyethylene-sorbitan-monolaureate), magnetic materials, streptavidin or biotin.

9. Container as claimed in one of claims 1 to 8, **characterised in that** the wells (5) are square, rectangular, conical or semi-spherical as seen from a side view.

10. Container as claimed in one of claims 1 to 9, wherein the wells (5) are round, quadrangular, such as square or rectangular, hexagonal, octagonal or in the shape of a parallelogram as seen in plan view.

11. Container as claimed in one of claims 1 to 10, **characterised in that** the wells (5), in particular the bases of the wells, are at least partially made from a transparent plastic.

12. Container as claimed in one of the preceding claims, **characterised in that** the base plate (3), in particular between the wells (5), is at least partially non-transparent.

13. Container as claimed in one of the preceding claims, **characterised in that** the surface (14) of the base plate (3), in particular between the wells (5), is surface-treated or has a hydrophobic mask applied to it.

14. Container as claimed in one of the preceding claims, **characterised in that** the base body (2) is made from a material selected from a group consisting of polypropylene, polystyrene, acrylo-butadiene-styrene, polyamide, polycarbonate, polymethyl methacrylate, polysulphone, cyclo-olefin copolymer, polymethyl pentene (TPX®) and/or styrene-acrylonitrile.

15. Container as claimed in one of the preceding claims, **characterised in that** the base body (2) is made from several different materials.

16. Container as claimed in one of the preceding claims, **characterised in that** a co-ordinate marker is provided for indicating the layout of the wells (5) in the base plate (3).

17. Container as claimed in one of the preceding claims, **characterised in that** the base body (2) is preferably made by an injection-moulding process.

18. Container as claimed in one of the preceding claims, **characterised in that** a recess (15) is provided on the longitudinal side (19) and/or on the transverse side (20) of the base body (2).

19. Container as claimed in one of the preceding claims, **characterised in that** the dimensions of the base body (2) conform to the recommendations of the SBS (Society of Biomolecular Screening).

20. Container as claimed in one of the preceding claims, **characterised in that** at least one retaining element (17) is provided on the side walls (4) of the container (1) for a unit (22) which sub-divides a volume of a container (1) into part-regions.

21. Container as claimed in one of claims 1 to 20, **characterised in that** the webs (23) of the unit (22) are enclosed by a frame (24) round the outside.

22. Container as claimed in one of claims 1 to 21, **characterised in that** spacers (25) are provided on the bottom face of the unit (22) to establish a flow connection between the part-regions.

23. Container as claimed in one of claims 1 to 22, **characterised in that** the webs (23) of the unit (22) are disposed at right-angles to one another.

24. Container as claimed in one of claims 1 to 23, **characterised in that** the height of the unit (22) in the intersecting regions (31) of the webs (23) or the webs (23) with the frame (24) is one third to a half higher than it is between the intersecting regions (31).

25. Container as claimed in one of claims 1 to 24, **characterised in that** the webs (23) and/or the frame (24) of the unit (22) are of identical height.

26. Container as claimed in one of claims 1 to 25, **characterised in that** the frame (24) has spacers (26) for holding the unit (22) at a distance from the side walls (4) of the container (1).

27. Container as claimed in one of claims 1 to 26, **characterised in that** the external dimensions of the unit (22) are slightly smaller than the dimensions of the container (1).

28. Container as claimed in one of claims 1 to 27, **characterised in that** the unit (22) is made from a material selected from a group consisting of polypropylene, polystyrene, acrylo-butadiene-styrene, polyamide, polycarbonate, polymethyl methacrylate, polysulphone, cyclo-olefin copolymer, polymethyl pentene and/or styrene-acrylo-nitrile.

29. Use of the container (1) as claimed in one of claims 1 to 28 for crystallising bio-macro molecules (11) in a crystallisation reagent (12) in or under a hydrophobic liquid (9).

30. Use of the container (1) with the unit (22) as claimed in one of claims 1 to 28 for reducing waves of a volume as it moves in a container.

## Revendications

1. Récipient avec un corps de base constitué d'une plaque de fond et des parois latérales s'éloignant de celle-ci au moins approximativement verticalement et avec des cuvettes aménagées dans le corps de base, qui sont conçues en tant que cavité dans la plaque de base (3), moyennant quoi les parois latérales (4) de la plaque de fond (3) sont disposées dans une direction au moins approximativement opposée par rapport aux cavités de logement d'un volume, **caractérisé en ce qu'**un dispositif en forme de grille (22) est prévu pour diviser le volume en zones partielles.

2. Récipient selon la revendication 1, **caractérisé en ce que** les cuvettes (5) sont disposées selon un motif régulier.

3. Récipient selon la revendication 1 ou 2, **caractérisé en ce que** 6, 12, 24, 48, 96, 384 ou 1356 cuvettes (5) sont disposées.

4. Récipient selon l'une quelconque des revendications 1 à 3, **caractérisé en ce que** les cuvettes (5) sont de forme conique ou cylindrique.

5. Récipient selon l'une quelconque des revendications 1 à 4, **caractérisé en ce que** les cuvettes (5) présentent une capacité sélectionnée dans un intervalle avec une limite inférieure de 0,01 µl, de préférence 0,5 µl, plus particulièrement 0,1 µl, et une limite supérieure de 50 µl, de préférence 10µl, plus particulièrement 5µl.

6. Récipient selon l'une quelconque des revendications 1 à 5, **caractérisé en ce que** les fonds (6) des cuvettes (5) sont disposés dans un plan parallèle à une surface d'appui du récipient.

7. Récipient selon l'une quelconque des revendications 1 à 6, **caractérisé en ce que** les fonds (6) respectivement les cuvettes (5) sont particulièrement traitées superficiellement pour la formation de bio-macromolécules (11).

8. Récipient selon l'une quelconque des revendications 1 à 7, **caractérisé en ce que** les cuvettes (5) sont traitées superficiellement avec un aldéhyde, un silane, un époxy, un thiol, du polyéthylène glycol (PEG), du monolauréate de polyoxyéthylène sorbitane, des matériaux magnétiques, de la streptavidine ou de la biotine.

9. Récipient selon l'une quelconque des revendications 1 à 8, **caractérisé en ce que** les cuvettes (5) présentent, en vue latérale, une forme carrée, rectangulaire, conique ou semi-sphérique.

10. Récipient selon l'une quelconque des revendications 1 à 9, **caractérisé en ce que** les cuvettes (5) présentent, en vue de dessus, une forme ronde, quadrangulaire, par exemple carrée, rectangulaire, hexagonale, octogonale ou la forme d'un parallélogramme.

11. Récipient selon l'une quelconque des revendications 1 à 10, **caractérisé en ce que** les cuvettes (5), plus particulièrement les fond des cuvettes, sont au moins partiellement constitués d'une matière plastique transparente.

12. Récipient selon l'une quelconque des revendications précédentes, **caractérisé en ce que** la plaque de fond (3), plus particulièrement entre les cuvettes (5), est au moins partiellement réalisée de manière non transparente.

13. Récipient selon l'une quelconque des revendications précédentes, **caractérisé en ce que** la surface (14) de la plaque de fond (3), plus particulièrement entre les cuvettes (5), est traitée avec une substance hydrophobe ou un masque hydrophobe est appliqué.

14. Récipient selon l'une quelconque des revendications précédentes, **caractérisé en ce que** le corps de base (2) est constitué d'un matériau sélectionné dans un groupe comprenant le polypropylène, le polystyrol, l'acrylbutadiène styrol, le polyamide, le polycarbonate, le polyméthylméthacrylate, le polysulfone, le copolymère de cyclooléfine, le polyméthylpentène et/ou le styrolacrylnitrile.

15. Récipient selon l'une quelconque des revendications précédentes, **caractérisé en ce que** le corps de base (2) est constitué de plusieurs matériaux différents.

16. Récipient selon l'une quelconque des revendications précédentes, **caractérisé en ce qu'**une identification des coordonnées est disposée pour la disposition des cuvettes (5) sur la plaque de fond (3).

17. Récipient selon l'une quelconque des revendications précédentes, **caractérisé en ce que** le corps de base (2) est réalisé de préférence à l'aide d'un procédé d'injection.

18. Récipient selon l'une quelconque des revendications précédentes, **caractérisé en ce que**, sur le côté longitudinal (19) et/ou le côté transversal (20) du corps de base (2) se trouve un évidement (15).

19. Récipient selon l'une quelconque des revendications précédentes, **caractérisé en ce que** le corps de base (2) présente des dimensions conformes aux recommandations de la SBS (Society of Biomolecular Screening).

20. Récipient selon l'une quelconque des revendications précédentes, **caractérisé en ce que**, sur les parois latérales (4) du récipient (1) se trouve au moins un élément de maintien (17) pour un dispositif (22) de division du volume d'un récipient (1) en zones partielles.

21. Récipient selon l'une quelconque des revendications 1 à 20, **caractérisé en ce que** les nervures (23) du dispositif (22) sont entourées à l'extérieur par un cadre (24).

22. Récipient selon l'une quelconque des revendications 1 à 21, **caractérisé en ce que**, sur le côté inférieur du dispositif (22) se trouvent des entretoises (25) permettant de relier les écoulements des zones partielles.

23. Récipient selon l'une quelconque des revendications 1 à 22, **caractérisé en ce que** les nervures (23) du dispositif (22) sont disposées perpendiculairement les unes par rapport aux autres.

24. Récipient selon l'une quelconque des revendications 1 à 23, **caractérisé en ce que** le dispositif (22) comprend, au niveau des zones de croisements (31) des nervures (23) respectivement au niveau des nervures(23) avec le cadre (24), une hauteur supérieure d'un tiers à une moitié à la hauteur entre les zones de croisements (31).

25. Récipient selon l'une quelconque des revendications 1 à 24, **caractérisé en ce que** les nervures (23) et/ou le cadre (24) du dispositif (22) présentent la même hauteur.

26. Récipient selon l'une quelconque des revendications 1 à 25, **caractérisé en ce que** le cadre (24) comprend des entretoises (26) pour le maintien du dispositif (22) à une certaine distance par rapport aux parois latérales (4) du récipient (1).

27. Récipient selon l'une quelconque des revendications 1 à 26, **caractérisé en ce que** les dimensions extérieures du dispositif (22) sont un peu inférieures aux dimensions du récipient (1).

28. Récipient selon l'une quelconque des revendications 1 à 27, **caractérisé en ce que** le dispositif (22) est constitué d'un matériau sélectionné dans un groupe comprenant le polypropylène, le polystyrol, l'acrylbutadiène styrol, le polyamide, le polycarbonate, le polyméthylméthacrylate, le polysulfone, le copolymère de cyclooléfine, le polyméthylpentène et/ou le styrolacrylnitrile.

29. Utilisation du récipient (1) selon l'une quelconque des revendications 1 à 28 pour la cristallisation de bio-macromolécules (11) dans un réactif de cristallisation (12) dans resp. sous un liquide hydrophobe (9).

30. Utilisation du récipient (1) avec le dispositif (22) selon l'une quelconque des revendications 1 à 28 pour l'atténuation des ondulations d'un volume déplacé dans un récipient.
